# FASCICULE DE BREVET EUROPEEN

(11) **EP 3 842 171 B1**
(45) Date de publication et mention de la délivrance du brevet: **06.07.2022**
(21) Numéro de dépôt: 20214871.4
(22) Date de dépôt: 17.12.2020
(51) Int. Cl.: B23B 45/02, B25F 5/02, H03K 17/97, H03K 17/95

(54) **DISPOSITIF DE PERÇAGE À ACTIONNEMENT OPTIMISÉ**
BOHRVORRICHTUNG MIT OPTIMIERTER BETÄTIGUNG
DRILLING DEVICE WITH OPTIMISED ACTIVATION

(30) Priorité: 24.12.2019 FR 1915567
(43) Date de publication de la demande: 30.06.2021
(73) Titulaire: ETABLISSEMENTS GEORGES RENAULT, 44800 Saint Herblain (FR)
(72) Inventeur: POIRIER, Kevin, 44300 NANTES (FR)
(74) Mandataire: Vidon Brevets & Stratégie

(56) Documents cités:
- DE-A1-102012 219 299
- US-A1- 2015 097 641

## Description

### 1. Domaine de l'invention

Le domaine de l'invention est celui des outils portatifs de perçage.

L'invention concerne plus particulièrement la gâchette d'actionnement d'un tel outil.

### 2. Art antérieur

Des outils portatifs de perçage sont couramment utilisés dans divers domaines comme par exemple dans celui de l'industrie aéronautique.

Le domaine de production aéronautique doit faire face à trois principaux défis techniques. Un premier défi résulte de ce que les avions sont actuellement constitués de nombreux matériaux, comme par exemple les composites carbone, l'aluminium ou alliage aluminium-lithium, le titane et l'acier. Ces différents matériaux ont des conditions de coupe différentes et leur empilement dans les structures avionnées complexifie les paramètres de coupe. Ainsi, pour garantir le maintien d'un niveau de qualité élevé des pièces finies élevé, une opération de perçage doit parfois se décomposer en plusieurs opérations. Ce séquençage augmente le coût global de fabrication des avions, que ce soit due à la multiplicité des perçages, à la précision accrue du positionnement des trous sur les divers éléments à percer et aux temps de manipulation des pièces à percer.

Un deuxième défi résulte de ce qu'un nombre important des perçages est réalisé de manière manuelle. Le maintien des pièces de structure des avions est assuré par un rivetage ou un boulonnage. Aux exigences de précision très élevées vis-à-vis du maintien de la structure en vol s'ajoute le fait que ces systèmes de maintien en position nécessitent la réalisation d'un très grand nombre de trous, de l'ordre de 750 000 à 1 500 000 perçages par avion. Une partie de ces perçages est réalisée grâce à des unités de perçage automatique (fixées sur des grilles de perçage assurant la fonction de gabarit) mais il en reste encore une grande quantité de perçage qui est réalisée à l'aide de perceuse manuelle pour des raisons d'encombrement ou de coût d'outillage. Cela peut représenter jusqu'à 70% des perçages réalisés par un site de production.

Un troisième défi résulte de ce quel l'évolution concurrentielle du secteur aéronautique impose de nouvelles exigences de cadence de production et d'amélioration de la productivité. Début 2016, Airbus prévoyait de produire 45 avions A350 en 2016, 80 en 2017 et 120 en 2018.

La nécessité d'augmenter la cadence de production nécessite de diminuer le temps dédié à chaque opération. L'opération de perçage manuel est une opération complexe qui dépend beaucoup des compétences de l'opérateur et qui peut amener de nombreux problèmes de non-respect de la qualité attendue (non-qualités). Ces non-qualités peuvent être dues à des problèmes d'états de surface, de bavures, d'écaillage, de délaminage, de dérive du diamètre, de formes, d'orientation... Celles-ci ont pour conséquences une diminution de la productivité et des coûts importants (1200€ par reprise de trou en moyenne, des millions d'euros par an).

Par exemple, pour éviter le délaminage lors du perçage du carbone il faut être capable de percer avec une vitesse de rotation très élevée. Lors d'un perçage d'un élément comprenant un empilement de plusieurs matériaux différents, il faudra aussi être capable de percer du titane à faible vitesse pour éviter l'échauffement qui pourrait détériorer la matière et engendrer une usure rapide de l'outil coupant. L'enjeu aujourd'hui est donc d'être en mesure d'ajuster au mieux les paramètres de coupe pour chaque phase spécifique du perçage.

Par conséquent, les constructeurs aéronautiques exigent désormais des moyens pour assister l'opération et la fiabiliser afin de réduire les non-qualités et ainsi augmenter la productivité.

Dans le domaine de l'industrie aéronautique, il est connu de réaliser les perçages manuels au moyen de perceuses pneumatiques manuelles. Ces perceuses ont été conçues à une époque où le perçage des alliages d'aluminium était prédominant. Ces perceuses ne proposent qu'une seule vitesse de perçage. Lorsqu'il s'agit d'assurer le perçage d'un empilement de plusieurs couches de matériaux différents, on choisit donc une perceuse dont la fréquence de rotation correspond à celle du matériau de l'empilement nécessitant la plus faible fréquence de rotation. Par exemple l'aluminium et le Titane requiert des fréquences de rotation de l'outil de coupe respectivement égales à 4500 tours par minutes et à 800 tours par minutes. Le perçage d'un empilement d'aluminium et de titane se fera donc au moyen d'une perceuse tournant à 800 tours par minutes. Ce choix pénalise donc la productivité et implique une qualité amoindrie pour la matière qui n'est pas percée avec les paramètres optimaux.

Par ailleurs, le tuyau d'air peut aussi être gênant pour la réalisation de certains trous dont l'accessibilité est compliquée.

Il est également connu de réaliser les perçages au moyen d'unités de perçage électriques à paramètres de coupe contrôlés. Ces unités de perçages sont volumineuses et fixes (donc non manuelles), et sont adaptées à des perçages de plus gros diamètres et facilement accessibles.

Les unités de perçage à paramètres de coupe contrôlés ne répondent pas au besoin d'outils portables, Ce sont des outils destinés à être fixé sur un bâti lors de l'action de perçage et ne sont donc pas maniables.

US 2015/0097641 A1 divulgue un dispositif de perçage ou de vissage portable selon le préambule de la revendication 1.

Les limites techniques de l'état de ces perceuses pneumatiques et électriques ne permettent donc pas de répondre à l'évolution des exigences de productivité et de flexibilité des outils dans le domaine de la production du secteur aéronautique.

La présente invention a donc pour but de faire évoluer l'état des techniques actuelles des perceuses manuelles afin de répondre aux défis techniques actuels imposés par la filière aéronautique.

### 3. Objectifs de l'invention

L'invention a notamment pour objectif d'apporter une solution efficace à au moins certains de ces différents problèmes.

En particulier, selon au moins un mode de réalisation, un objectif de l'invention est de procurer un dispositif de perçage électrique manuel qui soit flexible en termes de fréquences de rotation.

Notamment, l'invention a pour objectif, selon au moins un mode de réalisation, de fournir un tel dispositif qui offre la possibilité de choisir entre plusieurs fréquences de rotation.

Un autre objectif de l'invention, selon au moins un mode de réalisation, est de fournir un tel dispositif qui permette à son utilisateur de percevoir efficacement la fréquence de rotation à laquelle il le met en œuvre.

Notamment, l'invention a pour objectif, selon au moins un mode de réalisation, de fournir un tel dispositif qui soit simple et/ou robuste.

Un autre objectif de l'invention est, selon au moins un mode de réalisation, de fournir un tel dispositif qui soit fiable et efficace.

### 4. Présentation de l'invention

Pour ceci, l'invention propose un dispositif de perçage ou de vissage portable comprenant au moins :
- un moteur électrique ;
- des moyens autonomes ou filaires d'alimentation en électricité dudit moteur ;
- une gâchette d'actionnement ;
- des moyens de commande dudit moteur en fonction de la position de ladite gâchette ; ladite gâchette étant mobile entre au moins :
- une position de repos dans laquelle ledit moteur est à l'arrêt ;
- une position d'actionnement total dans laquelle ledit moteur est entrainé par lesdits moyens de commande selon une première fréquence de rotation prédéterminé ; ladite gâchette peut prendre une position intermédiaire prédéterminée dans laquelle elle se trouve entre lesdits positions de repos et d'actionnement et ledit moteur est entrainé par lesdits moyens de commande selon une deuxième fréquence de rotation prédéterminé.

Selon l'invention, un tel dispositif comprend des moyens de rappel élastique s'opposant au déplacement de ladite gâchette depuis sa position de repos vers sa position d'actionnement total, et des premiers moyens d'attraction magnétique fixes s'opposant au déplacement de ladite gâchette entre sa position intermédiaire et sa position d'actionnement total.

La mise en œuvre des moyens d'attraction magnétique constitue donc une butée magnétique d'arrêt dans la position intermédiaire dans laquelle l'outil fonctionne selon une fréquence de rotation prédéterminée. Cette butée magnétique peut être inhibée lorsque l'opérateur actionne la gâchette de manière suffisante pour s'opposer à l'effort d'attraction magnétique qu'elle exerce sur la gâchette et ainsi placer la gâchette dans la position d'actionnement total dans laquelle l'outil fonctionne à une autre fréquence de rotation.

Cette mise en œuvre permet ainsi à un opérateur de percevoir efficacement la position de la gâchette et en particulier son passage de la position intermédiaire à la position d'actionnement total. Il peut ainsi savoir de manière fiable, simple mais efficace à quelle fréquence de rotation il met en œuvre l'outil.

L'invention procure donc un outil de perçage électrique portable offrant deux fréquences de rotation et muni d'un système d'actionnement ergonomique et intuitif garantissant à l'opérateur de savoir à quelle fréquence de rotation son outil fonctionne.

Un dispositif de perçage selon l'invention est donc flexible, ergonomique et permet en conséquence de réaliser des perçages de qualité d'éléments multicouche avec un bon niveau de productivité.

Selon une caractéristique possible, ladite gâchette est mobile en translation le long d'un axe pour passer de l'une à l'autre de ses positions.

Selon une caractéristique possible, ladite gâchette est solidarisée à une extrémité d'un axe monté à l'intérieur d'une bague ferromagnétique, ledit axe et ladite bague étant mobiles en translation l'un par rapport à l'autre selon ledit axe, ladite bague comprenant une première extrémité contre laquelle ladite gâchette est susceptible de venir en appui et une deuxième extrémité susceptible de venir en contact avec lesdits premiers moyens d'attraction magnétique,
ladite gâchette se trouvant
- éloignée de ladite première extrémité dans les positions comprises entre la position de repos et la position intermédiaire
- au contact de ladite première extrémité dans les positions comprises entre la position intermédiaire et la position d'actionnement total.
   lesdits premiers moyens d'attraction magnétique étant dimensionnés de manière telle que ladite deuxième extrémité
- reste au contact desdits moyens d'attraction magnétique fixes lorsque ladite gâchette se trouve dans les positions entre la position de repos et la position intermédiaire.
- se trouve éloignée desdits moyens d'attraction magnétique fixes lorsque ladite gâchette se trouve dans les positions entre la position intermédiaire et la position d'actionnement total.

Selon une caractéristique possible, un dispositif selon l'invention comprend des deuxièmes moyens d'attraction magnétique positionnés à l'extrémité de ladite gâchette configurée pour venir au contact de ladite première extrémité de ladite bague.

Selon une caractéristique possible, lesdits premier et deuxième moyens d'attraction magnétique sont de forme annulaire, ladite bague et ledit axe passant à l'intérieur des premiers moyens d'attraction magnétique et ledit axe passant à l'intérieur des deuxièmes moyens d'attraction magnétique

Selon une caractéristique possible, un dispositif selon l'invention comprend un support pour lesdits premiers moyens d'attraction magnétique, ledit support comprenant un premier alésage dans lequel ladite bague est montée coulissante et un deuxième alésage formant un dégagement à l'intérieur duquel l'extrémité de ladite gâchette prévue pour venir au contact de ladite bague peut s'introduire lorsqu'elle est déplacée depuis sa position de repos vers sa position d'actionnement total.

Selon une caractéristique possible, lesdits moyens de rappel comprennent un ressort de compression interposé entre ledit support et ladite gâchette, ledit ressort ayant une extrémité logée dans ledit deuxième alésage et une autre extrémité logeant l'extrémité de ladite gâchette prévue pour venir au contact de ladite bague.

Selon une caractéristique possible, un dispositif selon l'invention comprend des moyens de détermination de la position de ladite gâchette, ledit moyens de détermination comprenant un premier capteur à effet hall et un aimant de détection solidaire de ladite gâchette.

Selon une caractéristique possible, lesdits moyens de détermination de la position de ladite gâchette comprennent un deuxième capteur à effet hall, lesdits premier et deuxième capteurs étant distants l'un de l'autre selon la trajectoire de déplacement de ladite gâchette.

Selon une caractéristique possible, ledit premier capteur à effet hall est de type analogique et ledit deuxième capteur à effet hall est de type numérique ou analogique. Selon une caractéristique possible, lesdites première et deuxième fréquences de rotation sont de même signe ou de signes opposés.

Selon une caractéristique possible, lequel lesdites première et deuxième fréquences de rotation ont des normes égales ou différentes.

### 5. Description des figures

D'autres caractéristiques et avantages de l'invention apparaîtront à la lecture de la description suivante de modes de réalisation particuliers, donnée à titre de simple exemple illustratif et non limitatif, et des dessins annexés parmi lesquels :
[Fig 1] la figure 1 illustre une vue en coupe transversale du dispositif de de perçage ;
[Fig 2] la figure 2 illustre une vue de côté partielle du dispositif de la figure 1 ;
[Fig 3] la figure 3 illustre une vue de détail de la gâchette du dispositif de la figure 2 ;
[Fig 4] la figure 4 illustre une vue éclatée de la gâchette de la figure 3 ;
[Fig 5] la figure 5 illustre la gâchette de la figure 4 en position repos ;
[Fig 6] la figure 6 illustre la gâchette de la figure 4 en position intermédiaire ;
[Fig 7] la figure 7 illustre la gâchette de la figure 4 en position d'actionnement total ;
[Fig 8] la figure 8 illustre la gâchette d'un dispositif sans amant de rappel en position repos ;
[Fig 9] la figure 9 illustre la gâchette d'un dispositif sans amant de rappel en position intermédiaire ;
[Fig 10] la figure 10 illustre une gâchette d'un dispositif sans amant de rappel en position d'actionnement total ;
[Fig 11] la figure 11 illustre un exemple variation du signal du premier capteur d'un dispositif bi capteurs ;
[Fig 12] la figure 12 illustre un exemple variation du signal du deuxième capteur d'un dispositif bi capteurs ;
[Fig 13] la figure 13 illustre la variation de l'effort appliqué par un opérateur sur la gâchette lors de son actionnement.

### 6. Description de modes de réalisation particuliers

### 6.1. Architecture

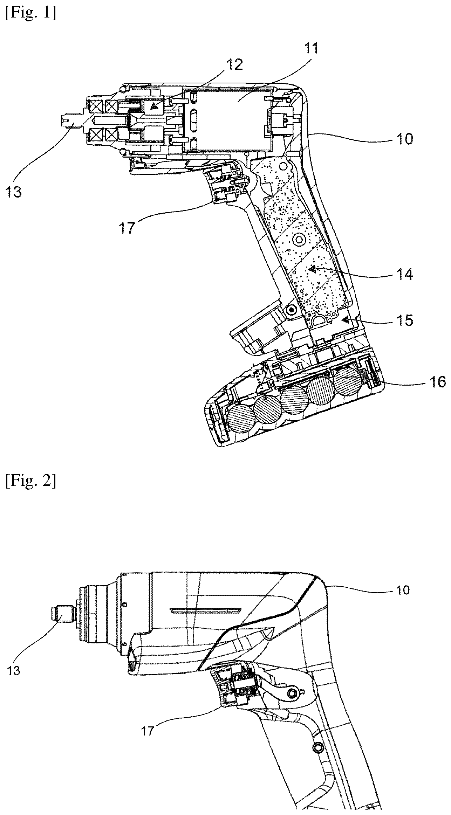

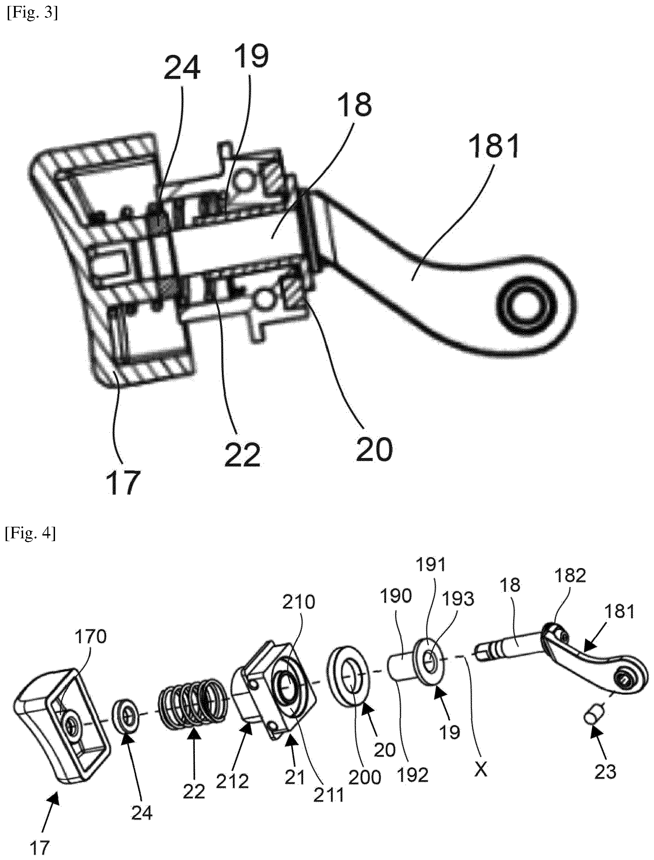

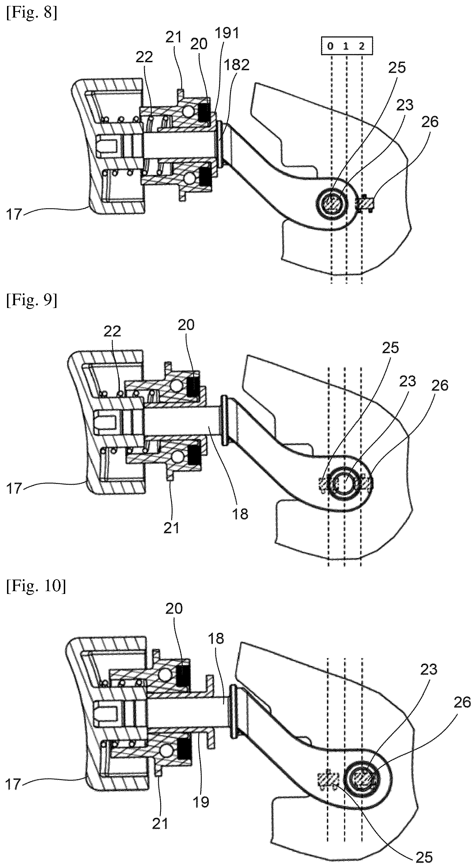

On présente en relation avec les figures 1 à 13 un exemple d'un dispositif de perçage selon l'invention. Il pourrait également s'agir d'un dispositif de vissage pouvant assurer la fonction de vissage ou les fonctions de vissage et de dévissage.

Ainsi que cela est représenté, un tel dispositif comprend un carter 10. Ce carter est ici de type poignée-pistolet (l'axe de la poignée forme un angle non nul avec l'axe de rotation de l'organe terminal). Il pourrait toutefois s'agir un carter longitudinal dont l'axe de la poignée est parallèle ou confondu avec l'axe de rotation de l'organe terminal, ou tout autre type de carter.

Ce carter 10 loge un moteur électrique 11. Il s'agit préférentiellement d'un moteur synchrone à aimant permanent. Il pourra toutefois s'agir de tout autre type de moteur électrique. L'arbre de sortie du moteur est relié à l'entrée d'une transmission 12 dont la sortie est reliée à un organe terminal 13 susceptible d'être entrainé en rotation via le moteur et la transmission.

L'organe terminal est prévu pour porter un outil coupant permettant de réaliser un perçage. Le carter loge des moyens de contrôle 14 du moteur. Ces moyens de contrôle, connu en soit et donc non décrit en détail, permettent de contrôler le moteur en régulation de vitesse. Le carter loge des moyens autonomes d'alimentation électrique du moteur. Ces moyens comprennent ici un onduleur 15 et une batterie 16. II pourrait s'agir de tout autres moyens autonomes d'alimentation comme une capacité ou autre. Il pourrait de manière alternative s'agit de moyens d'alimentation électrique filaires.

Le dispositif comprend une gâchette d'actionnement 17.

La gâchette 17 est solidarisée à une extrémité d'un axe 18 en matériau amagnétique, comme par exemple du bronze ou autre.

L'axe 18 est monté à l'intérieur d'une bague en matériau ferromagnétique 19.

La bague 19 comprend une portion cylindrique 190 prolongée par une collerette circulaire 191.

L'axe 18 et la bague 19 sont mobiles en translation l'un par rapport à l'autre selon un axe X correspondant à l'axe de translation de la gâchette 17.

La bague 19 comprenant une première extrémité 192 contre laquelle la gâchette 17 est susceptible de venir en appui et une deuxième extrémité, ici constituée par la collerette 191, susceptible de venir en contact avec des premiers moyens d'attraction magnétique qui comprennent ici un aimant annulaire 20 traversé par une ouverture centrale 200. Cet aimant, également appelé aimant de cran, pourra présenter toute autre forme adaptée. L'aimant 20 est monté sur un support 21 dans un logement 211 prévu à cet effet à une première extrémité. Le support 21 est solidarisé de manière fixe dans le carter et est traversé par un alésage 210. Il comprend un deuxième logement 212 à son autre extrémité prévu pour loger une extrémité d'un moyen de rappel élastique 22 comprenant ici un ressort de compression. Tout autre moyen de rappel élastique adapté pourra être utilisé comme un ressort à lame, un ressort spiral, un ressort de traction ou autre.

L'autre extrémité du ressort 22 est placée autour d'une saillie 170 de forme complémentaire ménagée dans la gâchette 17.

L'axe 18 présente à l'une de ses extrémités une collerette 182 et est prolongé par une platine 181 portant un aimant de détection 23.

La portion cylindrique 190 de la bague 19 est logée dans l'alésage 210 du support. L'axe 18 est monté coulissant à l'intérieur du perçage 193 de la bague 19.

Des deuxièmes moyens d'attraction magnétique, comprenant un aimant de rappel 24, sont solidarisés à l'extrémité de la saillie 170. De manière alternative, il est solidarisé à l'axe 18. Cet aimant est optionnel. Il présente également une forme annulaire mais pourrait présenter toute autre forme adaptée.

La gâchette est montée mobile en translation entre au moins :
- une position de repos dans laquelle le moteur est à l'arrêt ;
- une position d'actionnement total dans laquelle le moteur est entrainé par les moyens de commande selon une première fréquence de rotation prédéterminé ;
- une position intermédiaire dans laquelle elle se trouve entre les positions de repos et d'actionnement total et le moteur est entrainé par les moyens de commande selon une deuxième fréquence de rotation prédéterminé.

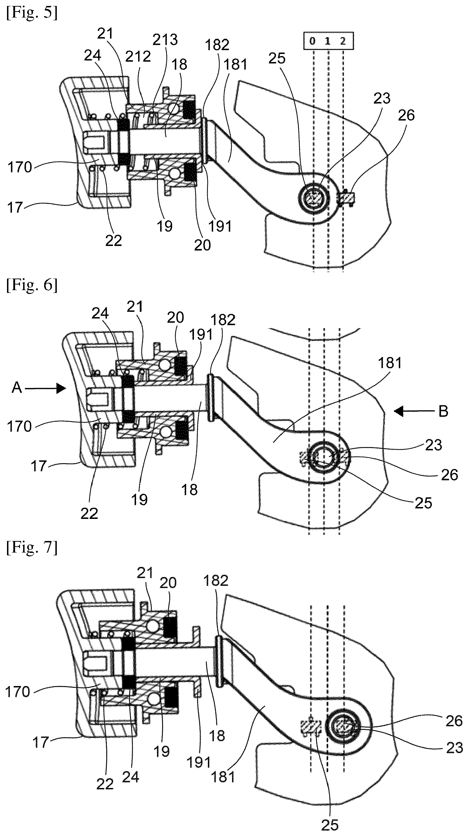

Lorsqu'un opérateur n'exerce aucun effort sur la gâchette 17, le ressort de compression 22 tend à la ramener dans sa position de repos illustrée à la figure 5.

Dans la position de repos, la gâchette 17 est le plus ressortie du carter. La collerette 182 de l'axe est en butée contre la collerette 191 de la bague, la collerette 191 de la bague est en butée contre l'aimant 20 et l'aimant 24 se trouve éloigné de l'extrémité 192 de la bague 18.

Lorsqu'un opérateur exerce sur la gâchette une force selon l'axe de déplacement de la gâchette en direction de l'intérieur du carter (cf. flèche A sur la figure 6), la gâchette se translate contre l'effort du ressort 22 qui se comprime. L'axe 18 coulisse à l'intérieur de la bague 19 et la collerette 182 de l'axe 18 s'éloigne de l'aimant 20. La gâchette est ainsi enfoncée jusqu'à ce que l'aimant 24 vienne en butée contre la première extrémité 192 de la bague 19. La collerette 191 de la bague demeure en contact avec l'aimant 20. La gâchette se trouve ainsi dans sa position intermédiaire.

Si l'opérateur souhaite placer la gâchette dans sa position d'actionnement total, il doit exercer sur celle-ci un effort plus important selon la flèche A. En effet, cet effort doit s'opposer à la somme de l'effort de compression du ressort 22 et de l'effort d'attraction magnétique exercé sur la bague par l'aimant 20. Lorsque l'effort exercé par l'opérateur pour enfoncer la gâchette vers sa position d'actionnement total est supérieur à cette somme, la bague 19 se décolle de l'aimant 20. La bague 19 et l'axe 18 sont alors déplacés en translation suivant la flèche A par la gâchette. Ce déplacement de fait jusqu'à ce que l'aimant 24 vienne en butée dans le fond 213 du logement 212. La gâchette se trouve alors dans sa position d'actionnement total (cf. figure 7).

La bague et l'aimant forment une butée magnétique pour la gâchette dont l'atteinte correspond à la position intermédiaire. L'aimant 20 est dimensionné pour déterminer un effort prédéterminé que l'opérateur doit exercer sur la gâchette pour quitter la position intermédiaire en direction de la position d'enclenchement total. L'aimant 20 s'oppose au déplacement de la gâchette au moins sur une portion initiale de sa course de déplacement entre sa position intermédiaire et sa position d'actionnement total. Lorsque la gâchette se trouve dans la position d'actionnement total, et que l'opérateur relâche la gâchette, le ressort 22 se détend et tend à agir sur la gâchette pour la déplacer vers la position intermédiaire suivant la flèche B. L'axe 28, solidaire de la gâchette, suit le même mouvement. Du fait que l'extrémité 192 de la bague est en contact avec l'aimant 24, la bague est également entrainée en translation jusqu'à ce que sa collerette 191 soit en butée contre l'aimant 20. L'opérateur perçoit ainsi le retour de la gâchette en position intermédiaire. Si l'opérateur continu de relâcher la gâchette, le ressort 22 continu de se détendre et exerce un effort suffisant important pour s'opposer à l'effort d'attraction magnétique de l'aimant 24. L'aimant 24 se décolle de la bague 19 qui reste en appui contre l'aimant 20. Le ressort déplace ensuite la gâchette jusqu'à ce que la collerette 182 de l'axe 18 soit en butée contre la collerette 191 de la bague. La gâchette se trouve alors dans sa position de repos.

L'aimant 24 permet, lorsque l'opérateur relâche avec douceur la gâchette tout en l'accompagnant pour la ramener de sa position d'actionnement total vers sa position de repos, de percevoir le retour dans la position intermédiaire. Il peut ainsi s'il le souhaite laisser la gâchette dans la position intermédiaire plutôt que de la ramener directement dans sa position de repos.

L'aimant 24 est optionnel et peut ne pas être mis en œuvre. Dans ce cas, la gâchette est susceptible de venir au contact de la bague directement. Lorsque l'aimant 24 n'est pas mis en œuvre, il est plus difficile voir pas possible pour l'opérateur de percevoir le retour de la gâchette dans sa position intermédiaire depuis la position d'actionnement total.

Dans ce mode de réalisation, il est prévu que les aimants 20 et 24 viennent directement au contact de la bague sur laquelle ils doivent exercer leurs efforts. Il se pourrait toutefois que ce contact soit indirect pourvu, c'est-à-dire qu'ils soient disposés par rapport à la bague pour lui transmettre leurs efforts d'attraction magnétique sans contact physique.

La forme annulaire des aimants 20 et 24 leur permet d'offrir des surfaces de contact de forme sensiblement identique à celles des surfaces de la bague et de la saillie 170 de la gâchette prévue pour venir en contact avec. Ceci permet de mieux répartir les efforts d'attraction magnétique transmis par les aimants à ces pièces.

Le dispositif selon l'invention comprend des moyens de détermination de la position de la gâchette.

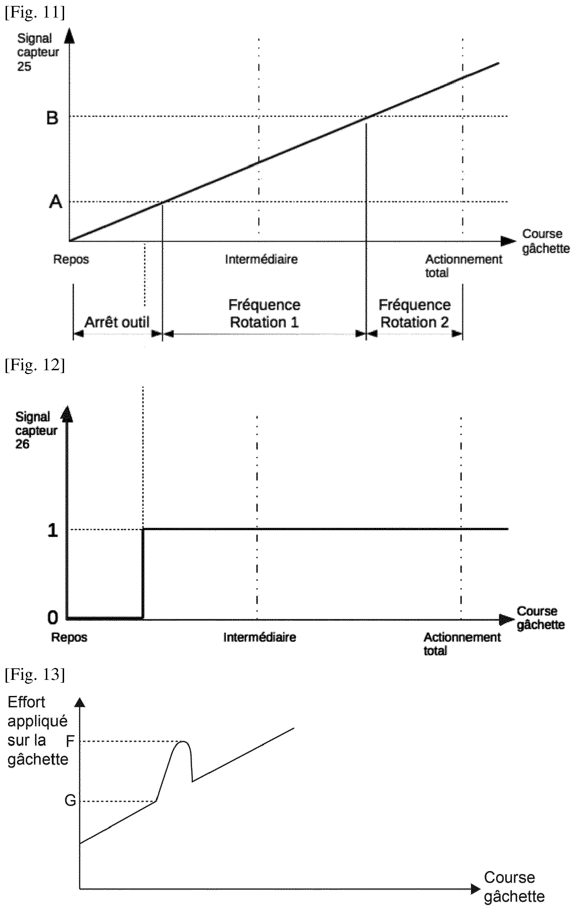

Ces moyens de détermination comprennent au moins un premier capteur 25, préférentiellement analogique, dont le signal est illustré à la figure 11.

Lorsque la gâchette se trouve dans sa position de repos, l'aimant de détection 23 est positionné par rapport au premier capteur de manière telle que l'information délivrée par le premier capteur 25 soit inférieure à une première valeur prédéterminée A.

Lorsque la gâchette se trouve dans sa position d'actionnement total, l'aimant de détection 23 est positionné par rapport au premier capteur de manière telle que l'information délivrée par le premier capteur 25 soit supérieure à une deuxième valeur prédéterminée B.

Lorsque la gâchette se trouve dans sa position intermédiaire, l'aimant de détection 23 est positionné par rapport au premier capteur de manière telle que l'information délivrée par le premier capteur 25 soit comprise entre les première et deuxième valeurs prédéterminées A et B.

Le capteur est relié aux moyens de commande du moteur qui pilotent et régulent le moteur en vitesse de sorte que :
- lorsque la gâchette de trouve dans la position de repos, le moteur ne soit pas alimenté et soit à l'arrêt,
- lorsque la gâchette se trouve dans la position intermédiaire, le moteur tourne à une première fréquence de rotation prédéterminée V1 ;
- lorsque la gâchette se trouve dans la position d'actionnement total, le moteur tourne à une deuxième fréquence de rotation prédéterminée V2.

Les première et deuxième fréquences de rotation peuvent être de même signe. Elles peuvent toutefois être de signes opposés, notamment mais non exclusivement lorsque la transmission et de type winch dans laquelle une inversion du sens de rotation du moteur permet d'enclencher des ratios de transmission de valeurs différentes. Des transmissions de ce type sont par exemple décrites dans les documents FR 3 000 694 et FR 2 913 361.

Les première et deuxième fréquences de rotation peuvent avoir des normes égales ou différentes.

Les moyens de détermination de la position de la gâchette peuvent alternativement comprendre en outre un deuxième capteur à effet hall 26.

Ces capteurs sont distants l'un de l'autre le long d'un axe sensiblement parallèle à l'axe de translation de la gâchette.

Le premier capteur est saturé lorsque l'aimant de détection est en face de lui.

Le premier capteur est préférentiellement de type analogique alors que le deuxième capteur est préférentiellement de type numérique. Le deuxième capteur pourra toutefois être également de type analogique.

Le deuxième capteur 26 est un capteur de sécurité permet de s'assurer de la position réelle de la gâchette ou de pallier un défaut sur le capteur 25.

Un défaut de maintien de l'aimant de détection 23 avec la platine 181 impliquerait un signal sur le capteur 25 supérieur à la valeur B et donc une consigne de fréquence de rotation V2 alors que la gâchette est en position repos et donc la consigne devrait être un arrêt moteur.

De même un défaut sur le capteur 25 pourrait générer un signal sur le capteur 25 supérieur à la valeur B et donc dans ce cas aussi une consigne de fréquence de rotation V2 alors que la gâchette est en position repos et donc la consigne devrait être un arrêt moteur.

Le seul premier capteur ne suffit donc pas à déterminer la position de la gâchette ou palier un défaut électronique.

L'utilisation du deuxième capteur permet d'y remédier. Pour cela, comme il est visible sur la figure 12 illustrant la variation de son signal en fonction de la position de la gâchette, ce capteur est dimensionné de telle sorte que son signal soit nul lorsque la gâchette est en position repos et soit non nul lorsque la gâchette se trouve en position intermédiaire et en position d'actionnement total, ou inversement.

Ainsi, la prise en considération des signaux délivrés par les deux capteurs permet aux moyens de contrôle du moteur de définir la position de la gâchette et de réguler en conséquence le moteur ainsi que de palier à un problème électronique sur le capteur 25. Dans l'exemple des figures 11 et 12, lorsque la valeur du premier capteur est inférieure à A et que le signal du deuxième capteur est nul, la gâchette est en position de repos. Lorsque la valeur du premier capteur est supérieure à B et que celle du deuxième capteur est non nulle, la gâchette est en position d'actionnement total. Lorsque la valeur du premier capteur est entre A et B et que celle du deuxième capteur est non nulle, la gâchette est en position intermédiaire.

La première fréquence de rotation est activée autour de la position intermédiaire, c'est-à-dire que le moteur est régulé à la première fréquence de rotation sur une plage autour de la position intermédiaire (première fréquence de rotation activée un peu avant l'atteinte de la position intermédiaire et maintenue un peu au-delà de la position intermédiaire). La deuxième fréquence de rotation est activée un peu avant l'atteinte de la position d'actionnement total et est maintenue un peu après que la gâchette quitte cette position vers la position intermédiaire.

Ce principe est illustré à la figure 11.

La mise en œuvre combinée du ressort de rappel 22 et de l'aimant de cran 20 permet à l'opérateur de percevoir le passage de la gâchette dans la position intermédiaire.

La figure 13 illustre la variation de l'effort appliqué par un opérateur sur la gâchette lors de son actionnement en fonction de la course de la gâchette.

Pour que l'opérateur perçoive correctement le passage de la gâchette dans la position intermédiaire, le rapport des valeurs F/G doit être préférentiellement compris entre 1.2 et 10.

## Revendications

1. Dispositif de perçage ou de vissage portable comprenant au moins :
- un moteur électrique (11) ;
- des moyens autonomes ou filaires d'alimentation en électricité dudit moteur (11) ;
- une gâchette d'actionnement (17) ;
- des moyens de commande dudit moteur (11) en fonction de la position de ladite gâchette (17) ;
ladite gâchette (17) étant mobile entre au moins :
- une position de repos dans laquelle ledit moteur (11) est à l'arrêt ;
- une position d'actionnement total dans laquelle ledit moteur (11) est entrainé par lesdits moyens de commande selon une première fréquence de rotation prédéterminé ; ladite gâchette (17) peut prendre une position intermédiaire prédéterminée dans laquelle elle se trouve entre lesdits positions de repos et d'actionnement et ledit moteur (11) est entrainé par lesdits moyens de commande selon une deuxième fréquence de rotation prédéterminé ;
le dispositif de perçage ou de vissage portable comprenant des moyens de rappel élastique (22) s'opposant au déplacement de ladite gâchette (17) depuis sa position de repos vers sa position d'actionnement total, et
**caractérisé en ce que** le dispositif de perçage ou de vissage portable comprend des premiers moyens d'attraction magnétique fixes s'opposant au déplacement de ladite gâchette (17) entre sa position intermédiaire et sa position d'actionnement total.

2. Dispositif selon la revendication 1 dans lequel ladite gâchette (17) est mobile en translation le long d'un axe (X) pour passer de l'une à l'autre de ses positions.

3. Dispositif selon la revendication 2 dans lequel ladite gâchette (17) est solidarisée à une extrémité d'un axe (18) monté à l'intérieur d'une bague ferromagnétique (19), ledit axe (18) et ladite bague (19) étant mobiles en translation l'un par rapport à l'autre selon ledit axe (18), ladite bague (19) comprenant une première extrémité (192) contre laquelle ladite gâchette (17) est susceptible de venir en appui et une deuxième extrémité (191) susceptible de venir en contact avec lesdits premiers moyens d'attraction magnétique, ladite gâchette (17) se trouvant :
- éloignée de ladite première extrémité (192) dans les positions comprises entre la position de repos et la position intermédiaire
- au contact de ladite première extrémité (192) dans les positions comprises entre la position intermédiaire et la position d'actionnement total,
lesdits premiers moyens d'attraction magnétique étant dimensionnés de manière telle que ladite deuxième extrémité (191) :
- reste au contact desdits premiers moyens d'attraction magnétique fixes lorsque ladite gâchette (17) se trouve dans les positions entre la position de repos et la position intermédiaire.
- se trouve éloignée desdits premiers moyens d'attraction magnétique fixes lorsque ladite gâchette (17) se trouve dans les positions au-delà de la position intermédiaire jusqu'à la position d'actionnement total.

4. Dispositif selon la revendication 3 comprend des deuxièmes moyens d'attraction magnétique solidarisés à l'extrémité de ladite gâchette (17) configurée pour venir au contact de ladite première extrémité (192) de ladite bague (19).

5. Dispositif selon la revendication 4 dans lequel lesdits premier et deuxième moyens d'attraction magnétique sont de forme annulaire, ladite bague (19) et ledit axe (18) passant à l'intérieur des premiers moyens d'attraction magnétique et ledit axe (18) passant à l'intérieur des deuxièmes moyens d'attraction magnétique.

6. Dispositif selon la revendication 5 comprenant un support (21) pour lesdits premiers moyens d'attraction magnétique, ledit support (21) comprenant un premier alésage (210) dans lequel ladite bague (19) est montée coulissante et un deuxième alésage (212) formant un dégagement à l'intérieur duquel l'extrémité de ladite gâchette (17) prévue pour venir au contact de ladite bague (19) peut s'introduire lorsqu'elle est déplacée depuis sa position de repos vers sa position d'actionnement total.

7. Dispositif selon la revendication 6 dans lequel lesdits moyens de rappel (22) comprennent un ressort de compression interposé entre ledit support (21) et ladite gâchette (17), ledit ressort (22) ayant une extrémité logée dans ledit deuxième alésage (212) et une autre extrémité logeant l'extrémité de ladite gâchette (17) prévue pour venir au contact de ladite bague (19).

8. Dispositif selon l'une quelconque des revendications 1 à 7 comprenant des moyens de détermination de la position de ladite gâchette (17), ledit moyens de détermination comprenant un premier capteur à effet hall (25) et un aimant de détection (23) solidaire de ladite gâchette (17).

9. Dispositif selon la revendication 8 dans lequel lesdits moyens de détermination de la position de ladite gâchette (17) comprennent un deuxième capteur à effet hall (26), lesdits premier et deuxième capteurs (25, 26) étant distants l'un de l'autre selon la trajectoire de déplacement de ladite gâchette (17).

10. Dispositif selon la revendication 8 ou 9 dans lequel ledit premier capteur à effet hall (25) est de type analogique et ledit deuxième capteur à effet hall (26) est de type numérique ou analogique.

11. Dispositif selon l'une quelconque des revendications 1 à 10 dans lequel lesdites première et deuxième fréquences de rotation sont de même signe ou de signes opposés.

12. Dispositif selon l'une quelconque des revendications 1 à 10 dans lequel lesdites première et deuxième fréquences de rotation ont des normes égales ou différentes.

## Patentansprüche

1. Tragbare Bohr- oder Schraubvorrichtung umfassend wenigstens:
- einen Elektromotor (11);
- unabhängige oder drahtgebundene Mittel zur Stromversorgung des Motors (11);
- einen Betätigungsabzug (17);
- Mittel zur Steuerung des Motors (11) in Abhängigkeit von der Position des Abzugs (17);
wobei der Abzug (17) wenigstens zwischen folgenden Positionen bewegbar ist:
- einer Ruheposition, in welcher sich der Motor (11) im Stillstand befindet;
- einer Vollauslösungsposition, in welcher der Motor (11) von den Mittel zur Steuerung mit einer ersten vorbestimmten Drehfrequenz angetrieben wird; wobei der Abzug (17) eine vorbestimmte Zwischenposition einnehmen kann, in welcher er sich zwischen der Ruhe- und der Vollauslösungsposition befindet und der Motor (11) von den Mittel zur Steuerung mit einer zweiten vorbestimmten Drehfrequenz angetrieben wird;
wobei die tragbare Bohr- oder Schraubvorrichtung elastische Rückstellmittel (22) umfasst, die der Bewegung des Abzugs (17) aus dessen Ruheposition zu dessen Vollauslösungsposition entgegenwirken, und
**dadurch gekennzeichnet, dass** die Bohr- oder Schraubvorrichtung erste feste Mittel zur magnetischen Anziehung umfasst, die der Bewegung des Abzugs (17) zwischen dessen Zwischenposition und dessen Vollauslösungsposition entgegenwirken.

2. Vorrichtung nach Anspruch 1, wobei der Abzug (17) entlang einer Achse (X) translatorisch beweglich ist, um aus der einen zur anderen seiner Positionen zu wechseln.

3. Vorrichtung nach Anspruch 2, wobei der Abzug (17) mit einem Ende einer Achse (18) fest verbunden ist, die innerhalb eines ferromagnetischen Rings (19) angebracht ist, wobei die Achse (18) und der Ring (19) bezogen aufeinander entlang der Achse (18) translatorisch beweglich sind, wobei der Ring (19) ein erstes Ende (192), gegen welches der Abzug (17) in Anlage kommen kann, und ein zweites Ende (191), das mit den ersten Mitteln zur magnetischen Anziehung in Kontakt treten kann, umfasst, wobei der Abzug (17):
- in den Positionen zwischen der Ruheposition und der Zwischenposition vom ersten Ende (192) entfernt ist
- in den Positionen zwischen der Zwischenposition und der Vollauslösungsposition mit dem ersten Ende (192) in Kontakt steht,
wobei die ersten Mittel zur magnetischen Anziehung so bemessen sind, dass das zweite Ende (191):
- mit den ersten festen Mitteln zur magnetischen Anziehung in Kontakt bleibt, wenn sich der Abzug (17) in den Positionen zwischen der Ruheposition und der Zwischenposition befindet,
- von den ersten festen Mitteln zur magnetischen Anziehung entfernt ist, wenn sich der Abzug (17) in den Positionen über die Zwischenposition hinaus bis zur Vollauslösungsposition befindet.

4. Vorrichtung nach Anspruch 3, umfassend zweite Mittel zur magnetischen Anziehung, die mit dem Ende des Abzugs (17) fest verbunden sind, der dazu ausgebildet ist, mit dem ersten Ende (192) des Rings (19) in Kontakt zu treten.

5. Vorrichtung nach Anspruch 4, wobei das erste und zweite Mittel zur magnetischen Anziehung ringförmig ist, wobei der Ring (19) und die Achse (18) innerhalb der ersten Mittel zur magnetischen Anziehung und die Achse (18) innerhalb der zweiten Mittel zur magnetischen Anziehung verlaufen.

6. Vorrichtung nach Anspruch 5 umfassend einen Halter (21) für die ersten Mittel zur magnetischen Anziehung, wobei der Halter (21) eine erste Bohrung (210), in welcher der Ring (19) gleitend gelagert ist, und eine zweite Bohrung (212) umfasst, die eine Ausnehmung bildet, in welche das Ende des Abzugs (17), der dafür vorgesehen ist, mit dem Ring (19) in Kontakt zu treten, eindringen kann, wenn er aus seiner Ruheposition zu seiner Vollauslösungsposition bewegt wird.

7. Vorrichtung nach Anspruch 6, wobei die Rückstellmittel (22) eine Druckfeder umfassen, die zwischen dem Halter (21) und dem Abzug (17) angeordnet ist, wobei die Feder (22) ein Ende, das in der zweiten Bohrung (212) aufgenommen ist, und ein anderes Ende aufweist, das das Ende des Abzugs (17) aufnimmt, der dafür vorgesehen ist, mit dem Ring (19) in Kontakt zu treten.

8. Vorrichtung nach einem der Ansprüche 1 bis 7 umfassend Mittel zur Bestimmung der Position des Abzugs (17), wobei die Mittel zur Bestimmung einen ersten Hall-Effekt-Sensor (25) und einen Detektionsmagneten (23), der mit dem Abzug (17) fest verbunden ist, umfassen.

9. Vorrichtung nach Anspruch 8, wobei die Mittel zur Bestimmung der Position des Abzugs (17) einen zweiten Hall-Effekt-Sensor (26) umfassen, wobei der erste und zweite Sensor (25, 26) je nach der Bewegungsbahn des Abzugs (17) voneinander beabstandet sind.

10. Vorrichtung nach Anspruch 8 oder 9, wobei der erste Hall-Effekt-Sensor (25) vom analogen Typ und der zweite Hall-Effekt-Sensor (26) vom digitalen oder analogen Typ ist.

11. Vorrichtung nach einem der Ansprüche 1 bis 10, wobei die erste und zweite Drehfrequenz dasselbe Vorzeichen oder gegensätzliche Vorzeichen aufweisen.

12. Vorrichtung nach einem der Ansprüche 1 bis 10, wobei die erste und zweite Drehfrequenz gleiche oder verschiedene Normen aufweisen.

## Claims

1. Portable drilling or screw driving device comprising at least:
- an electric motor (11);
- autonomous or wired means for supplying electricity to said motor (11);
- an actuating trigger (17);
- means for controlling said motor (11) as a function of the position of said trigger (17);
said trigger (17) being capable of moving between at least:
- a rest position in which said motor (11) is at a stop;
- a fully actuated position in which said motor (11) is driven by said means for controlling at a first predetermined rotational frequency;
said trigger (17) can assume a predetermined intermediate position in which it is located between said rest and actuated positions and said motor (11) is driven by said means for controlling at a second predetermined rotational frequency;
the portable drilling or screw driving device comprising elastic return means (22) opposing the displacement of said trigger (17) from the rest position thereof to the fully actuated position thereof, and **characterised in that** the portable drilling or screw driving device comprises first fixed magnetic attraction means opposing the displacement of said trigger (17) between the intermediate position thereof and the fully actuated position thereof.

2. Device according to claim 1, wherein said trigger (17) is capable of moving in translation along an axis (X) to switch from one of its positions to another.

3. Device according to claim 2, wherein said trigger (17) is integral with one end of a shaft (18) mounted inside a ferromagnetic ring (19), said shaft (18) and said ring (19) being capable of moving in translation relatively to one another along said shaft (18), said ring (19) comprising a first end (192) against which said trigger (17) is capable of abutting and a second end (191) capable of coming into contact with said first magnetic attraction means, said trigger (17) being located:
- at a distance from said first end (192) in the positions comprised between the rest position and the intermediate position,
- in contact with said first end (192) in the positions comprised between the intermediate position and the fully actuated position,
said first magnetic attraction means being sized such that said second end (191):
- remains in contact with said first fixed magnetic attraction means when said trigger (17) is located in the positions between the rest position and the intermediate position,
- is located at a distance from said first fixed magnetic attraction means when said trigger (17) is located in positions beyond the intermediate position as far as the fully actuated position.

4. Device according to claim 3, comprising second magnetic attraction means integral with the end of said trigger (17) configured to come into contact with said first end (192) of said ring (19).

5. Device according to claim 4, wherein said first and second magnetic attraction means are annular in shape, said ring (19) and said shaft (18) passing into the interior of the first magnetic attraction means and said shaft (18) passing into the interior of the second magnetic attraction means.

6. Device according to claim 5, comprising a support (21) for said first magnetic attraction means, said support (21) comprising a first bore (210) in which said ring (19) is mounted such that it can slide, and a second bore (212) forming a clearance into which the end of said trigger (17) intended to come into contact with said ring (19) can be inserted when displaced from the rest position thereof to the fully actuated position thereof.

7. Device according to claim 6, wherein said return means (22) comprise a compression spring sandwiched between said support (21) and said trigger (17), said spring (22) having one end housed in said second bore (212) and another end housing the end of said trigger (17) intended to come into contact with said ring (19).

8. Device according to any one of claims 1 to 7, comprising means for determining the position of said trigger (17), said means for determining comprising a first Hall effect sensor (25) and a detection magnet (23) integral with said trigger (17).

9. Device according to claim 8, wherein said means for determining the position of said trigger (17) comprise a second Hall effect sensor (26), said first and second sensors (25, 26) being spaced apart from one another along the displacement trajectory of said trigger (17).

10. Device according to claim 8 or 9, wherein said first Hall effect sensor (25) is of the analogue type and said second Hall effect sensor (26) is of the digital or analogue type.

11. Device according to any one of claims 1 to 10, wherein said first and second rotational frequencies are of the same or opposite signs.

12. Device according to any one of claims 1 to 10, wherein said first and second rotational frequencies have equal or different norms.
